# DEMANDE DE BREVET EUROPEEN

(11) **EP 3 840 017 A1**
(43) Date de publication de la demande: **23.06.2021**
(21) Numéro de dépôt: 20215210.4
(22) Date de dépôt: 17.12.2020
(51) Int. Cl.: H01L 21/20

(54) **PROCÉDÉ DE FORMATION D'UNE COUCHE PAR ÉPITAXIE CYCLÉE**

(30) Priorité: 18.12.2019 FR 1914803
(71) Demandeur: Commissariat à l'Energie Atomique et aux Energies Alternatives, 75015 Paris (FR)
(72) Inventeur: MAZZOCCHI, Vincent, 38054 GRENOBLE CEDEX 09 (FR); MAITREJEAN, Sylvain, 38054 GRENOBLE CEDEX 09 (FR)
(74) Mandataire: Hautier, Nicolas

(57) **Abrégé**

Selon un aspect, l'invention prévoit un procédé de formation d'une couche par épitaxie cyclée comprenant au moins une séquence d'étapes comprenant chacune au moins les étapes successives suivantes :
- premier dépôt par épitaxie de sorte à former,
▪ une première portion (110) de couche de croissance, d'épaisseur e₁₁₀, formée sur un premier motif (100) monocristallin et
▪ une deuxième portion (210) de couche de croissance, d'épaisseur e₂₁₀, formée sur un deuxième motif (200) non monocristallin, avec e₂₁₀ > e₁₁₀,

- deuxième dépôt par épitaxie de sorte à former
▪ une première portion (120) de couche sacrificielle, d'épaisseur e₁₂₀, sur la première portion (110) de couche de croissance,
▪ une deuxième portion (220) de couche sacrificielle, d'épaisseur e₂₁₀, sur la deuxième portion (210) de couche de croissance,
les première (110) et deuxième (210) couche de croissance présentant une teneur t1 en un élément additionnel, supérieure à la teneur t2 de cet élément additionnel présent dans les première (120) et deuxième (220) couches sacrificielles,
- gravure de toute l'épaisseur e₂₂₀ et de toute l'épaisseur e₂₁₀ avec arrêt de la gravure avant d'avoir consommé toute l'épaisseur e₁₁₀.

## Description

### DOMAINE TECHNIQUE

L'invention concerne, de manière générale, le domaine des procédés de dépôt par épitaxie. Elle trouve pour application, particulièrement avantageuse, le domaine des procédés de dépôt par épitaxie cyclée, afin de former une couche épitaxiée sur un motif monocristallin d'une plaque, sans former de couche sur un autre motif de la plaque, cet autre motif n'étant pas monocristallin.

### ETAT DE LA TECHNIQUE

La réalisation de nombreux dispositifs micro-électroniques nécessite de déposer par épitaxie une couche sur des motifs monocristallins d'une plaque sans pour autant déposer cette couche sur des motifs non monocristallins de cette plaque.

Typiquement, il peut être nécessaire de déposer par épitaxie une couche à base de silicium sur des motifs monocristallins, sans pour autant déposer de couches sur des motifs non monocristallins, tels que des motifs amorphes, formés d'un oxyde ou d'un nitrure par exemple.

Une solution pour y parvenir consiste à réaliser une épitaxie cyclée. Une épitaxie cyclée consiste à réitérer des séquences d'étapes comprenant chacune une étape de dépôt par épitaxie suivie d'une étape de gravure sélective permettant de graver préférentiellement la couche déposée sur le motif non monocristallin par rapport au matériau épitaxié sur le motif monocristallin.

Après plusieurs séquences, il est possible d'obtenir une couche épitaxiée d'épaisseur souhaitée sur les motifs monocristallins tout en conservant les motifs non monocristallins découverts.

Dans certains cas, cette solution d'épitaxie cyclée ne s'avère pas efficace. Cela est notamment le cas lorsque les vitesses de dépôt sont plus importantes sur le motif amorphe que sur le motif monocristallin.

Il existe donc un besoin pour former, à partir d'un dépôt par épitaxie, une couche sur des motifs monocristallins d'une plaque sans pour autant former cette couche sur d'autres motifs, non monocristallins, de la plaque.

Les autres objets, caractéristiques et avantages de la présente invention apparaîtront à l'examen de la description suivante et des dessins d'accompagnement. Il est entendu que d'autres avantages peuvent être incorporés.

### RESUME

Pour atteindre cet objectif, selon un mode de réalisation la présente invention prévoit un procédé de formation d'une couche par épitaxie cyclée comprenant au moins et possiblement uniquement les étapes suivantes :
- fournir une plaque comprenant au moins un premier motif monocristallin et au moins un deuxième motif pris parmi un motif amorphe ou un motif polycristallin,
- effectuer au moins une séquence d'étapes comprenant chacune au moins les étapes successives suivantes :
   ∘ premier dépôt, de préférence par épitaxie, de sorte à former :
   ▪ une première portion de couche de croissance formée par épitaxie sur le premier motif et présentant une épaisseur e₁₁₀ et
   ▪ une deuxième portion de couche de croissance formée sur le deuxième motif et présentant une épaisseur e₂₁₀
au moins du fait de la différence de structure cristalline entre les premier et deuxième motifs, à l'issue du premier dépôt, les épaisseurs e₂₁₀ et e₁₁₀ sont telles que e₂₁₀>e₁₁₀.

Le premier dépôt étant réalisé à partir d'une première chimie comprenant une première espèce semi-conductrice et une espèce additionnelle présentant une première teneur t1 dans la première chimie.
∘ deuxième dépôt, de préférence par épitaxie, de sorte à former:
▪ une première portion de couche sacrificielle formée par épitaxie sur la première portion de couche de croissance et présentant une épaisseur e₁₂₀ et
▪ une deuxième portion de couche sacrificielle formée sur la deuxième portion de couche de croissance et présentant une épaisseur e₂₂₀.

Le deuxième dépôt est réalisé à partir d'une deuxième chimie comprenant une deuxième espèce semi-conductrice et présentant une deuxième teneur t2 en ladite espèce additionnelle. t2 est telle 0≤t2<t1.
∘ gravure de toute l'épaisseur e₂₂₀ de la deuxième portion de couche sacrificielle, d'une partie au moins et de préférence de toute de l'épaisseur e₁₂₀ de la première portion de couche sacrificielle et de toute ou partie de l'épaisseur e₂₁₀ de la deuxième portion de couche de croissance avec arrêt de la gravure avant d'avoir consommé toute ou partie de l'épaisseur e₁₁₀ de la première portion de couche de croissance.

Dans le cadre du développement de la présente invention, il s'est avéré que les vitesses de gravure fluctuent fortement en fonction de la structure cristallographique de la couche déposée ainsi que de la concentration en espèce additionnelle dans cette couche, typiquement un niveau de dopage de la couche déposée.

En particulier, il a été observé que :
- le différentiel de vitesse de gravure entre des parties monocristallines et des parties non monocristallines est très important pour des couches semi-conductrices présentant un niveau de dopage nul ou très faible, la vitesse de gravure sur les parties non monocristallines étant plus importante. En revanche, ce différentiel a tendance à décroître lorsque l'on augmente le niveau de dopage.
- la vitesse de croissance sur les parties monocristallines est toujours plus faible que sur les parties non monocristallines.

Le procédé proposé tire profit de ces observations. Ainsi, quand bien même le premier dépôt forme une couche de croissance bien plus épaisse sur les parties non monocristallines que sur les parties monocristallines, le fort différentiel de gravure entre la couche sacrificielle de la partie monocristalline et la couche sacrificielle de la partie non monocristalline permet de consommer l'ensemble des dépôts formés sur les parties non monocristallines tout en conservant une portion au moins de la couche de croissance déposée sur la partie monocristalline.

Le procédé proposé permet ainsi de s'affranchir des fluctuations fortes portant sur les vitesses de dépôt sur les parties monocristallines et sur les parties non monocristallines.

L'invention offre ainsi une solution simple et fiable pour déposer par épitaxie une couche semi-conductrice uniquement sur des motifs monocristallins.

Selon un exemple non limitatif, les conditions du premier et deuxième dépôts, notamment la première teneur et la deuxième teneur, ainsi que les conditions de la gravure étant réglées de sorte à ce que ;
- Vg220> k.Vg120, Vg120 et Vg220 étant respectivement les vitesses de gravure de la première portion de couche sacrificielle et de la deuxième portion de couche sacrificielle, k étant supérieure ou égal à 2,
- l'épaisseur e₁₂₀ de la première portion de couche sacrificielle formée par le deuxième dépôt soit suffisante pour que, après ladite gravure, il subsiste une portion au moins de l'épaisseur e₁₁₀ de la première portion de couche de croissance déposée sur le premier motif. Ainsi, selon cet exemple, à l'issue de l'étape de gravure de chaque cycle, l'épaisseur e₁₂₀ de la première portion de couche sacrificielle est entièrement retirée. Cela permet d'augmenter le temps de gravure pour graver la deuxième portion de couche de croissance, tout en permettant de conserver entièrement la première portion de couche de croissance ou d'en retirer une très faible épaisseur. Cela permet ainsi de résoudre la problématique consistant à faire croître de manière rapide une couche cristalline sélectivement aux zones non cristallines.

De préférence, e>0 et e₁₁₀ > e₂₁₀.

Selon un autre aspect, la présente invention porte sur un procédé de formation d'une couche par épitaxie cyclée comprenant au moins les étapes suivantes :
- fournir une plaque comprenant au moins un premier motif monocristallin et au moins un deuxième motif pris parmi un motif amorphe ou un motif polycristallin,
- effectuer au moins une séquence d'étapes comprenant chacune au moins les étapes successives suivantes :
   ∘ premier dépôt, de préférence par épitaxie, de sorte à former :
   ▪ une première portion de couche de croissance formée par épitaxie sur le premier motif et présentant une épaisseur e₁₁₀ et
   ▪ une deuxième portion de couche de croissance formée sur le deuxième motif et présentant une épaisseur e₂₁₀
au moins du fait de la différence de structure cristalline entre les premier et deuxième motifs, à l'issue du premier dépôt, les épaisseurs e₂₁₀ et e₁₁₀ sont telles que e₂₁₀>e₁₁₀.

Le premier dépôt étant réalisé à partir d'une première chimie comprenant une première espèce semi-conductrice et une espèce additionnelle, la première teneur t1 de espèce additionnelle dans la première chimie étant choisie de sorte que la première portion et de la deuxième portion de la couche de croissance présentent une concentration c1 en espèce additionnelle.
∘ deuxième dépôt, de préférence par épitaxie, de sorte à former:
▪ une première portion de couche sacrificielle formée par épitaxie sur la première portion de couche de croissance et présentant une épaisseur e120 et
▪ une deuxième portion de couche sacrificielle formée sur la deuxième portion de couche de croissance et présentant une épaisseur e210.

Le deuxième dépôt étant réalisé à partir d'une deuxième chimie comprenant une deuxième espèce semi-conductrice et présentant une deuxième teneur t2 en ladite espèce additionnelle, la deuxième teneur t2 de espèce additionnelle étant choisie de sorte que la première portion et de la deuxième portion de la couche sacrificielle présentent une concentration c2 en espèce additionnelle, telle que 0≤c2<c1.

### BREVE DESCRIPTION DES FIGURES

Les buts, objets, ainsi que les caractéristiques et avantages de l'invention ressortiront mieux de la description détaillée de modes de réalisation de cette dernière qui sont illustrés par les dessins d'accompagnement suivants dans lesquels :
La figure 1A illustre, de manière schématique, un exemple de structure pouvant servir de base de départ pour réaliser le procédé selon l'invention.
La figure 1B est un graphe illustrant, en fonction du débit d'une espèce additionnelle telle qu'un dopant, la vitesse de croissance de dépôt par épitaxie (échelle des ordonnées à gauche) ainsi que la vitesse de gravure (échelle des ordonnées à droite), pour des couches surmontant respectivement un motif monocristallin et un motif amorphe.
La figure 2A illustre, de manière schématique, la structure de la figure 1A après dépôt d'une couche de croissance et dépôt d'une couche sacrificielle sur un motif cristallin et un motif non monocristallin.
La figure 2B reprend le graphe de la figure 2A, en mentionnant les valeurs retenues pour les débits de l'espèce additionnelle d'une part pour le premier dépôt et d'autre part pour le deuxième dépôt illustrés en figure 2A.
La figure 3A illustre, de manière schématique, la structure de la figure 2A après une étape de gravure laissant en place une portion au moins de la couche de croissance sur le motif monocristallin et conduisant au retrait de la couche de croissance ainsi que de la couche sacrificielle surmontant le motif non monocristallin.
La figure 3B reprend le graphe de la figure 2A, en mentionnant les valeurs applicables aux vitesses de gravures pour l'étape de gravure illustrée en figure 3A.
La figure 4A illustre, de manière schématique, la structure de la figure 3A après des étapes de dépôts additionnels correspondant aux dépôts illustrés en figure 2B.
La figure 4B, reprend le graphe de la figure 2A, en mentionnant les valeurs retenues pour les débits de l'espèce additionnelle d'une part pour le premier dépôt et d'autre part pour le deuxième dépôt illustrés en figure 4A.
La figure 5A illustre, de manière schématique, la structure de la figure 4A après une étape de gravure laissant en place une portion au moins de la couche de croissance sur le motif monocristallin et conduisant au retrait de la couche de croissance ainsi que de la couche sacrificielle surmontant le motif non monocristallin.
La figure 5B reprend le graphe de la figure 2A, en mentionnant les valeurs applicables aux vitesses de gravures pour l'étape de gravure illustrée en figure 5A.
La figure 6A illustre, de manière schématique, la structure de la figure 5A après des étapes de dépôts additionnels correspondant aux dépôts illustrés en figure 2B.
La figure 6B, reprend le graphe de la figure 2A, en mentionnant les valeurs retenues pour les débits de l'espèce additionnelle d'une part pour le premier dépôt et d'autre part pour le deuxième dépôt illustrés en figure 6A.
La figure 7A illustre, de manière schématique, la structure de la figure 6A après une étape de gravure laissant en place une portion au moins de la couche de croissance sur le motif monocristallin et conduisant au retrait de la couche de croissance ainsi que de la couche sacrificielle surmontant le motif non monocristallin.
La figure 7B reprend le graphe de la figure 2A, en mentionnant les valeurs applicables aux vitesses de gravures pour l'étape de gravure illustrée en figure 7A.
La figure 8 illustre sous forme d'ordinogramme les étapes principales d'un procédé selon la présente invention.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier, les épaisseurs relatives des différentes couches de croissance et des couches sacrificielles ne sont pas représentatives de la réalité.

### DESCRIPTION DÉTAILLÉE

Avant d'entamer une revue détaillée de modes de réalisation de l'invention, sont énoncées ci-après des caractéristiques optionnelles qui peuvent éventuellement être utilisées en association ou alternativement :
Selon un mode de réalisation, le premier motif et le deuxième motif sont réalisés dans des matériaux identiques. Ainsi, la nature chimique du matériau déposé lors du premier dépôt et celle du matériau déposé lors du deuxième dépôt diffèrent uniquement par des teneurs en ladite espèce additionnelle. Alternativement, le premier motif et le deuxième motif sont réalisés dans des matériaux différents.
Selon un exemple, le premier motif est fait d'un matériau à base d'élément de la colonne IV du tableau périodique, de préférence le premier motif est en Si, en SixGey, en SixGeySnz, en SixCy ou en Ge (x et y étant des entiers non nuls).
Selon un exemple, le deuxième motif est fait d'un matériau à base d'élément de la colonne IV du tableau périodique, de préférence le premier motif est en Si, en SixGey, en SixGeySnz, en SixCy ou en Ge (x et y étant des entiers non nuls).
Selon un exemple, le deuxième motif effet d'un matériau diélectrique. Selon un exemple, le deuxième motif est un oxyde ou un nitrure. Il peut par exemple s'agir d'un oxyde de silicium SiₓO_{y} ou d'un nitrure de silicium SiₓN_{y}, x et y étant des entiers.

Les premiers et deuxième motif présente des tailles identiques ou différentes, la taille d'un motif étant de préférence la surface de ce motif exposée à une croissance par épitaxie. Il s'agit donc de la surface du motif à partir de laquelle la croissance par épitaxie peut s'opérer

Selon un exemple, ladite première espèce semi-conductrice et ladite deuxième espèce semi-conductrice sont identiques.

Alternativement, ladite première espèce semi-conductrice et ladite deuxième espèce semi-conductrice sont différentes.

Selon un exemple, la première espèce semi-conductrice est à base de silicium. Selon un exemple, la première portion de couche de croissance et la deuxième portion de couche de croissance sont des couches à base de silicium. Elles sont en Si ou en SiGe, additionné de l'élément additionnel.

Alternativement, la première portion de couche de croissance et la deuxième portion de couche de croissance sont des couches en Ge additionné de l'élément additionnel.

Alternativement, la première portion de couche de croissance et la deuxième portion de couche de croissance sont des couches en SiGeSn additionné de l'élément additionnel.

Selon un exemple, la première portion de couche de croissance et la deuxième portion de couche de croissance sont des couches à base de l'un parmi le silicium et le germanium, la première portion de couche sacrificielle et la deuxième portion de couche sacrificielle étant également des couches à base de l'un parmi le silicium et le germanium.

La nature du précurseur comportant l'espèce semi conductrice et le débit de ce précurseur sont choisis de sorte à ce que la concentration de l'espèce additionnelle au sein de la couche déposée au cours de la première étape de dépôt soit supérieure ou égale à 5.E19 at/cm³.

Selon un exemple, l'espèce additionnelle est un dopant, c'est-à-dire toute espèce capable de changer les propriétés de conduction électrique de la couche formée par épitaxie. Selon un exemple, l'espèce additionnelle est prise parmi le phosphore, le bore, l'arsénique ou l'antimoine.

Alternativement, l'espèce additionnelle est le carbone (C).

Selon un exemple, la deuxième teneur t2 est nulle. Cela signifie que la chimie de dépôt ne comprend pas d'espèce additionnelle. Si le dépôt est effectué à l'aide d'un réacteur, le débit d'injection de l'espèce additionnelle dans ce réacteur est nul. Il s'ensuit que la concentration c en espèce additionnelle dans la couche déposée est également nulle.

Selon un exemple, la première portion de couche sacrificielle et la deuxième portion de couche sacrificielle sont entièrement retirées à l'issue de l'étape de gravure de chaque cycle. Ainsi, lors de chaque cycle, les épaisseurs e₁₂₀ et e₂₂₀ sont entièrement gravées. Cela permet de faire pleinement jouer aux première et deuxième portions de couche sacrificielle leur rôle de couches sacrificielles. La gravure de la deuxième portion de couche de croissance est ainsi importante alors que la gravure de la première portion de couche de croissance peut être nulle ou faible.

Selon un exemple, la deuxième espèce semi-conductrice est à base de silicium. Selon un exemple, la première portion de couche sacrificielle et la deuxième portion de couche sacrificielle sont des couches à base de silicium. Elles sont en Si ou en SiGe, éventuellement additionné d'un élément additionnel.

Alternativement, la première portion de couche sacrificielle et la deuxième portion de couche sacrificielle sont des couches en Ge additionné de l'élément additionnel.

Selon un mode de réalisation, l'espèce additionnelle du premier dépôt est identique à l'espèce additionnelle du deuxième dépôt.

Selon un mode de réalisation, la première portion de couche de croissance et la deuxième portion de couche de croissance sont faites de silicium dopé au phosphore (Si :P) et la première portion de couche sacrificielle et la deuxième portion de couche sacrificielle sont faites de silicium (Si).

Selon un autre mode de réalisation, la première portion de couche de croissance et la deuxième portion de couche de croissance sont faites de silicium-germanium dopé au bore (SiGe :B) et la première portion de couche sacrificielle et la deuxième portion de couche sacrificielle sont faites de silicium-germanium (SiGe).

Selon un exemple, à chaque cycle, la gravure grave toute l'épaisseur e₂₁₀ et toute l'épaisseur e₂₂₀, et conserve toute l'épaisseur e₁₁₀ de la première portion de couche de croissance déposée sur le premier motif. Ainsi, à l'issue de chaque cycle, il subsiste toute l'épaisseur e₁₁₀ de la première portion de couche de croissance.

Selon un exemple, les conditions de la gravure, en particulier V_{g120}, V_{g220}, V_{g220} et les épaisseurs e₁₂₀ et e₁₁₀ sont réglées de sorte que, après gravure de toute l'épaisseur e₂₁₀ et de toute l'épaisseur e₂₂₀, il subsiste toute l'épaisseur e₁₁₀ de la première portion de couche de croissance déposée sur le premier motif.

Selon un exemple l'épaisseur e₁₁₀ de la première portion de couche de croissance et l'épaisseur e₂₁₀ de la deuxième portion 210 de couche de croissance sont comprises entre 2 nm et 100 nm et de préférence entre 2 nm et 50 nm.

Selon un exemple, les épaisseurs e₁₂₀ de la première portion de couche sacrificielle et e₂₂₀ de la deuxième portion de couche sacrificielle sont comprises entre 2 nm et 50 nm et de préférence entre 2 nm et 20 nm.

Selon un exemple, après le premier dépôt et après le deuxième dépôt, lors de ladite gravure on grave également toute l'épaisseur e₂₁₀ de la deuxième portion de couche de croissance.

Selon un exemple, le procédé comprend, après avoir effectué l'au moins une séquence d'étapes, une étape de gravure finale configurée pour retirer un éventuel résidu de la deuxième portion de couche de croissance.

Selon un exemple, cette étape de gravure finale est basée sur une chimie à base de chlore (Cl).

Selon un exemple, on effectue au moins deux fois et de préférence au moins trois fois ladite séquence d'étapes.

Selon un exemple, les premières et deuxièmes couches de croissance sont directement au contact des première et deuxième portions de couches sacrificielles respectivement.

On entend par un substrat, un film, une couche, « à base » d'un matériau A, un substrat, un film, une couche comprenant ce matériau A uniquement ou ce matériau A et éventuellement d'autres matériaux, par exemple une espèce additionnelle tel qu'un dopant.

Dans la présente invention, on qualifie d'espèce dopante ou de dopant une espèce capable de modifier les propriétés de conduction électrique du matériau dans laquelle cette espèce implantée.

Le mot « diélectrique » qualifie un matériau dont la conductivité électrique est suffisamment faible dans l'application donnée pour servir d'isolant.

Il est précisé que, dans le cadre de la présente invention, les termes « sur », « surmonte », « recouvre », « sous-jacent », en « vis-à-vis » et leurs équivalents ne signifient pas forcément « au contact de ». Ainsi par exemple, le dépôt, le report, le collage, l'assemblage ou l'application d'une première couche sur une deuxième couche, ne signifie pas obligatoirement que les deux couches sont directement au contact l'une de l'autre, mais signifie que la première couche recouvre au moins partiellement la deuxième couche en étant soit directement à son contact, soit en étant séparée d'elle par au moins une autre couche ou au moins un autre élément.

Une couche peut par ailleurs être composée de plusieurs sous-couches d'un même matériau ou de matériaux différents.

On entend par « nature » d'un matériau, sa composition chimique et/ou sa structure cristalline. Ainsi deux couches peuvent être de même composition chimique mais de nature différente d'un point de vue cristallographique.

Dans la présente invention, un dopage signifie que l'espèce dopante est présente dans la couche déposée avec une concentration supérieure ou égale à 1 atome de l'espèce dopante pour moins de 1000 atomes du semi-conducteur et de préférence pour moins de 10 à 100 atomes du matériau formant la couche semi-conductrice.

Dans la présente invention des types de dopage seront indiqués. Ces dopages sont des exemples non limitatifs. L'invention couvre tous les modes de réalisation dans lesquels les dopages sont inversés. Ainsi, si un exemple de réalisation mentionne pour une première zone un dopage P et pour une deuxième zone un dopage N, la présente description décrit alors, implicitement au moins, l'exemple inverse dans lequel la première zone présente un dopage N et la deuxième zone un dopage P.

Un autre objet de la présente invention concerne un dispositif microélectronique comprenant une pluralité de transistors selon l'invention. Par dispositif microélectronique, on entend tout type de dispositif réalisé avec des moyens de la microélectronique. Ces dispositifs englobent notamment en plus des dispositifs à finalité purement électronique, des dispositifs micromécaniques ou électromécaniques (MEMS, NEMS...) ainsi que des dispositifs optiques ou optoélectroniques (MOEMS...).

Il est précisé que dans le cadre de la présente invention, l'épaisseur d'une couche se mesure selon une direction perpendiculaire à la surface selon laquelle cette couche ou un substrat sur laquelle repose cette couche présente son extension maximale.

Si la couche est déposée sur une plaque, alors son épaisseur est prise perpendiculairement aux faces parallèles de cette plaque.

Sur les figures, l'épaisseur est prise selon la verticale.

De même lorsqu'on indique qu'un élément est situé au droit d'un autre élément, cela signifie que ces deux éléments sont situés tous deux sur une même ligne perpendiculaire au plan principal du substrat, soit sur une même ligne orientée verticalement sur les figures.

On notera que dans la présente invention, on qualifie de teneurs d'une espèce soit la teneur de cette espèce dans la chimie servant au dépôt d'une couche, la chimie étant par exemple celle formée dans un réacteur de dépôt par épitaxie. Cette teneur peut alors par exemple être fonction du ratio du débit du gaz comprenant cette espèce sur le débit de l'ensemble des gaz injectés dans le réacteur.

On notera que dans la présente invention, on qualifie de concentration d'une espèce, la teneur de cette espèce dans la couche déposée où le matériau déposé comprenant cette espèce.

Une concentration sera par exemple mesurée en atomes par centimètre cube (at/cm³), en utilisant par exemple la technologie SIMS, acronyme du vocable anglais Secondary Ion Mass Spectrometry signifiant (Spectrométrie de masse des ions secondaires.

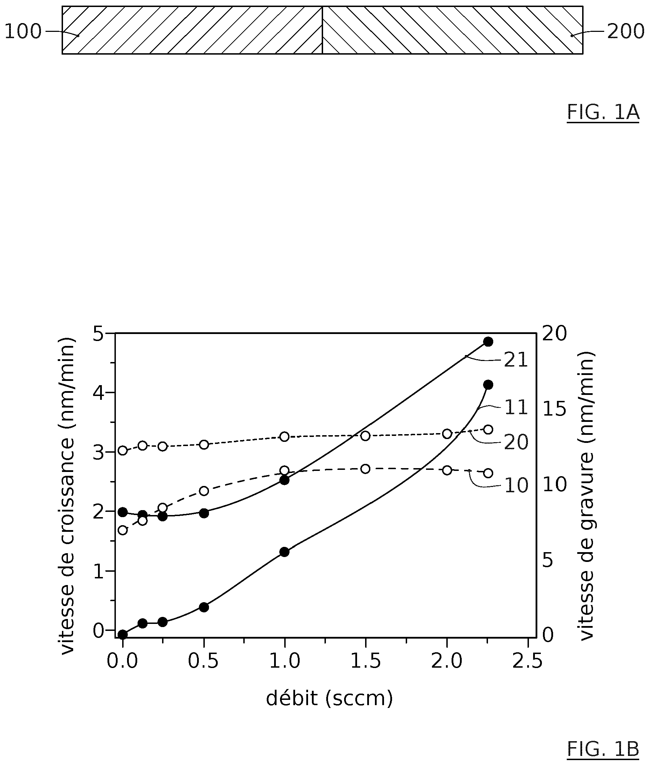

Un exemple non limitatif de procédé selon l'invention va maintenant être décrit en référence aux figures 1A à 8.

Comme illustré en figure 1A, une première étape consiste à fournir une structure présentant au moins un premier motif 100, monocristallin, et au moins un deuxième motif 200, qui n'est pas monocristallin.

Ces motifs 100, 200 sont par exemple formés sur une plaque, tel qu'un wafer habituellement utilisé dans l'industrie de la micro-électronique. Ces motifs 100, 200 peuvent être adjacents, comme illustré en figure 1A pour faciliter la compréhension de l'invention, ou distants l'un de l'autre. Dans ce dernier cas, ils peuvent être coplanaires et peuvent présenter la même épaisseur. Ainsi, leurs faces inférieures peuvent être contenues dans un même plan et leurs faces supérieures peuvent également être contenues dans un même plan. Alternativement, l'une ou l'autre des faces inférieures et supérieures des motifs 100, 200 peuvent appartenir à des plans différents. Pour une application à une structure en trois dimensions, cette dernière alternative est préférée.

À titre d'exemple non limitatif, les motifs 100 et 200 peuvent présenter une épaisseur comprise entre 1 nm et 500nm.

De préférence, le motif 100 est formé dans un matériau semi-conducteur, par exemple à base de silicium (Si), de germanium (Ge) ou de silicium-germanium (SiGe).

Selon un exemple, le motif 200 est fait d'un matériau diélectrique, Tel qu'un oxyde ou un nitrure. De préférence, le motif 200 est également formé à base d'un matériau semi-conducteur tel que le silicium, le germanium (Ge) ou le silicium-germanium (SiGe). Ainsi, si ce motif 200 est un oxyde ou un nitrure, il s'agit d'un oxyde de silicium SiₓO_{y} ou d'un nitrure de silicium SiₓN_{y}, x et y étant des entiers.

Selon un exemple de réalisation, les motifs 100, 200 sont formés à partir d'un même matériau. Tel est par exemple le cas, si ces motifs 100, 200 sont formés à partir d'une même couche de silicium puis que des parties de cette couche destinée à définir les deuxièmes motifs 200 font l'objet d'une étape d'oxydation ou de nitruration. On peut également prévoir que ces motifs 100, 200 soient formés d'un même matériau présentant un état cristallin différent.

Dans l'exemple illustré à travers le graphe de la figure 1B, le motif 100 est en silicium monocristallin et le motif 200 est en silicium amorphe. Toutes les caractéristiques et les avantages qui seront mentionnés par la suite en référence à ces motifs sont également applicables à des motifs présentant une autre nature, typiquement à des motifs 100, 200 qui ne sont pas en silicium et à des motifs 200 qui ne sont pas amorphes mais polycristallins.

La figure 1B représente, une vitesse de croissance (courbes 10, 20) ou une vitesse de gravure (courbes 11, 21) en fonction du débit d'une espèce additionnelle injectée dans l'équipement utilisé, pour effectuer des dépôts ou une gravure. Plus précisément :
- la courbe 10 illustre la vitesse de croissance par épitaxie d'une couche à base de silicium sur un motif monocristallin 100.
- la courbe 20 illustre la vitesse de croissance d'une couche à base de silicium surmontant un motif non monocristallin, ici un motif amorphe 200.

Les vitesses de croissance se lisent sur l'axe des ordonnées situé à gauche du graphe. Ces vitesses sont exprimées en nanomètres (10⁻⁹ m) par minute.
- La courbe 11 illustre la vitesse de gravure d'une couche monocristalline déposée sur le motif 100 monocristallin, en étant directement ou non au contact de ce motif 100.
- La courbe 21 illustre la vitesse de gravure d'une couche non monocristalline déposée sur le motif 200 amorphe, en étant directement ou non au contact de ce motif 200.

Les vitesses de gravure se lisent sur l'axe des ordonnées situé à droite du graphe. Ces vitesses de croissance et de gravure sont exprimées en nanomètres (10⁻⁹ m) par minute. Les épaisseurs sont mesurées selon une direction perpendiculaire au plan surfacique principal selon lequel les motifs 100, 200 s'étendent. Sur les figures, l'épaisseur se mesure selon une direction verticale.

L'analyse des courbes 10 et 20 montre que la vitesse de croissance sur les motifs monocristallins 100 est toujours plus faible que sur les motifs 200 amorphes. Le rapport des vitesses de croissance V_{c210} / V_{c110} (avec V_{c210} = vitesse de croissance V_{c210} sur les motifs amorphes 200 et V_{c110}= vitesse de croissance V_{c110} sur les motifs amorphes 100) est relativement fort dans le cas où l'espèce additionnelle est absente ou présente en faible quantité. En effet, ce rapport V_{c210} / V_{c110} est environ égal à 2 en l'absence d'espèce additionnelle. Ce rapport se réduit lorsque l'on ajoute une espèce additionnelle, puis tend à se stabiliser. Pour un débit de 1 sccm de PH₃, pris comme espèce additionnelle, à une température de 500 °C, la vitesse de dépôt sur motifs monocristallins 100 est d'environ 2,5 nanomètres par minute (nm/min), alors que cette vitesse est d'environ 3,2 nm/min sur motifs amorphes 200. Ainsi, ce rapport V_{c210} / V_{c110} n'est plus que de 1,28.

L'analyse des courbes 11 et 21 montre que la vitesse V_{g1} de gravure sur les motifs 100 monocristallins est très inférieure à la vitesse V_{g2} de gravure sur les motifs 200 amorphes dans le cas où l'espèce additionnelle est absente ou présente en faible quantité dans la chimie utilisée pour effectuer le dépôt par épitaxie (typiquement inférieure à 0.1 sccm dans ce cas).

Il apparaît sur l'exemple de ce graphe de la figure 1B que pour une espèce additionnelle PH₃ introduite avec un débit de 0,025 sccm, V_{g1} ≈ 0,85 nm/min et V_{g2} ≈ 8,2 nm/min. Le rapport R=V_{g2}/V_{g1} est alors environ de 9,6, ce qui signifie que la couche déposée sur les motifs 200 amorphes se grave 9,6 fois plus vite que la couche déposée sur les motifs 100 monocristallins.

En revanche, la vitesse V_{g1} de gravure sur les motifs 100 monocristallins se rapproche de la vitesse V_{g2} de gravure sur les motifs 200 amorphes dans le cas où l'espèce additionnelle est présente en plus grande quantité.

Ainsi, il apparaît sur ce graphe de la figure 1B qu'avec un débit de PH₃ de 2,25 sccm, V_{g1} ≈ 17 nm/min et V_{g2} ≈ 20 nm/min. Le rapport V_{g2}/V_{g1} est alors environ de 1,18, ce qui très inférieure (plus de 8 fois inférieures) au rapport V_{g2}/V_{g1} obtenu pour un débit PH₃ de 0,025 sccm.

Lorsque l'espèce additionnelle est injectée avec un débit de 0.5sccm, ce rapport R des vitesses de gravure est environ égal à 4,4.

Comme cela sera indiqué en détail par la suite, l'invention tire profit de ces fluctuations des vitesses de croissance et du rapport R de vitesses de gravure en fonction d'une part de la concentration en espèce additionnelle dans la chimie servant au dépôt (et donc de la teneur en espèce additionnelle au sein des couches déposées) et d'autre part en fonction de la nature cristalline du motif à partir desquels les couches sont déposées par épitaxie.

A cet effet, l'invention prévoit, après un premier dépôt d'une couche semi-conductrice présentant une concentration c1 en espèce additionnelle, de réaliser un deuxième dépôt d'une couche semi conductrice présentant une concentration c2 nulle ou strictement inférieure à c1. Ce deuxième dépôt fait office de couche d'arrêt pour stopper la gravure avant de consommer le premier dépôt réalisé sur les motifs 100 monocristallins, ceci alors même que ce deuxième dépôt n'empêche pas la gravure réalisée sur les motifs 200 amorphes ou polycristallins.

L'espèce additionnelle est par exemple une espèce dopante.

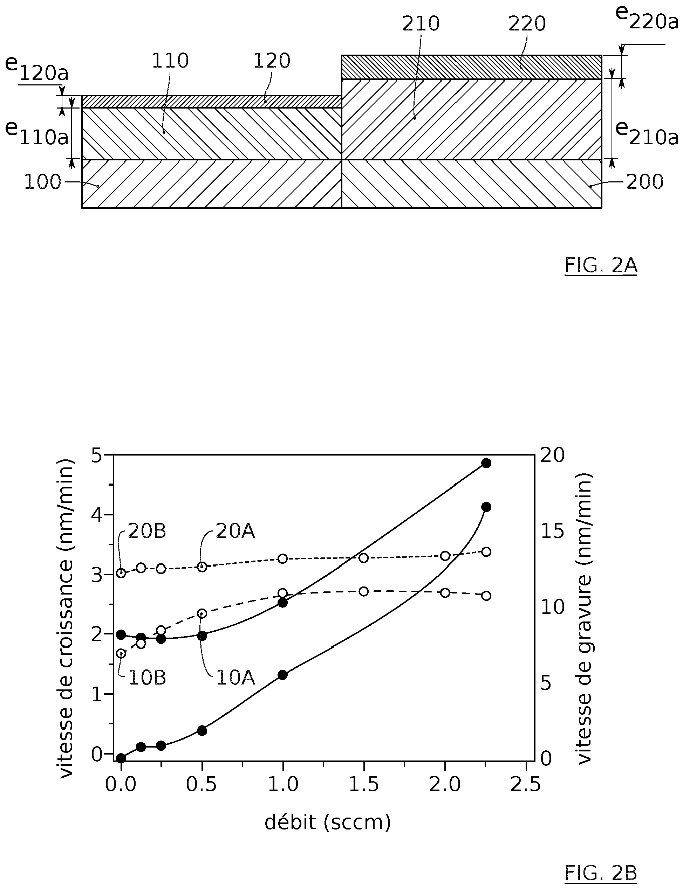

Plus précisément à partir de l'étape illustrée en figure 1A, on effectue une séquence, et de préférence au moins deux, voire plus de séquences, comprenant chacune les étapes suivantes :
- un premier dépôt, comme illustré en figures 2A, 4A, 6A, en présence d'une teneur t1 en l'espèce additionnelle dans la chimie de dépôt, de sorte à former :
   ∘ une première portion 110 de couche de croissance, épitaxiée, d'épaisseur e₁₁₀, sur le motif monocristallin 100. La première portion 110 de couche de croissance présente une concentration c1 en espèce additionnelle ;
   ∘ une deuxième portion 210 de couche de croissance, d'épaisseur e₂₁₀, sur le motif non monocristallin 200. La deuxième portion 210 de couche de croissance présente une concentration c1 en espèce additionnelle. ;

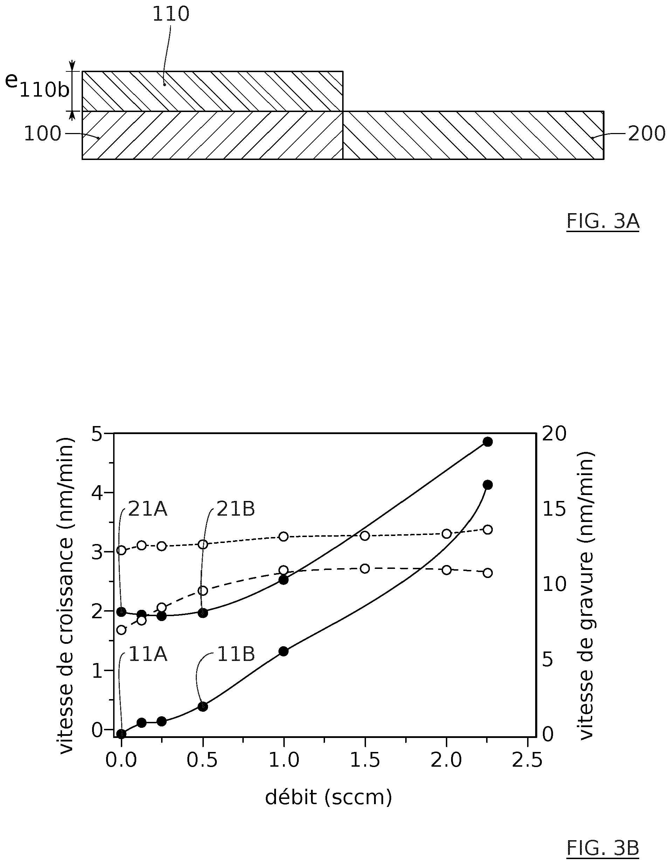

Au cours de cette étape, la nature du précurseur comportant l'espèce semi conductrice ainsi que le débit de ce précurseur et le débit du précurseur comportant l'espèce additionnelle sont choisis de sorte à ce que la concentration c1 de l'espèce additionnelle au sein de la couche déposée soit supérieure ou égale à 5.10¹⁹ atomes par centimètres cube.
- un deuxième dépôt, comme illustré en figures 2A, 4A, 6A, avec une teneur t2 en ladite espèce additionnelle dans la chimie de dépôt, telle que t2< t1 de sorte à former :
   ∘ une première portion 120 de couche sacrificielle, d'épaisseur e₁₂₀, sur la première portion 110 de couche de croissance ;
   ∘ une deuxième portion 220 de couche sacrificielle, d'épaisseur e₂₂₀, sur la deuxième portion 210 de couche de croissance ;
- une gravure, comme illustré en figures 3A, 5A, 7A:
   ∘ de la deuxième portion 220 de couche sacrificielle sur toute son épaisseur e₂₂₀,
   ∘ de la deuxième portion 210 de couche de croissance sur toute son épaisseur e₂₁₀,
   ∘ d'une partie au moins de la première portion 120 de couche sacrificielle,
   ∘ avec arrêt avant consommation de toute l'épaisseur e₁₁₀ de la première portion 110 de couche de croissance.

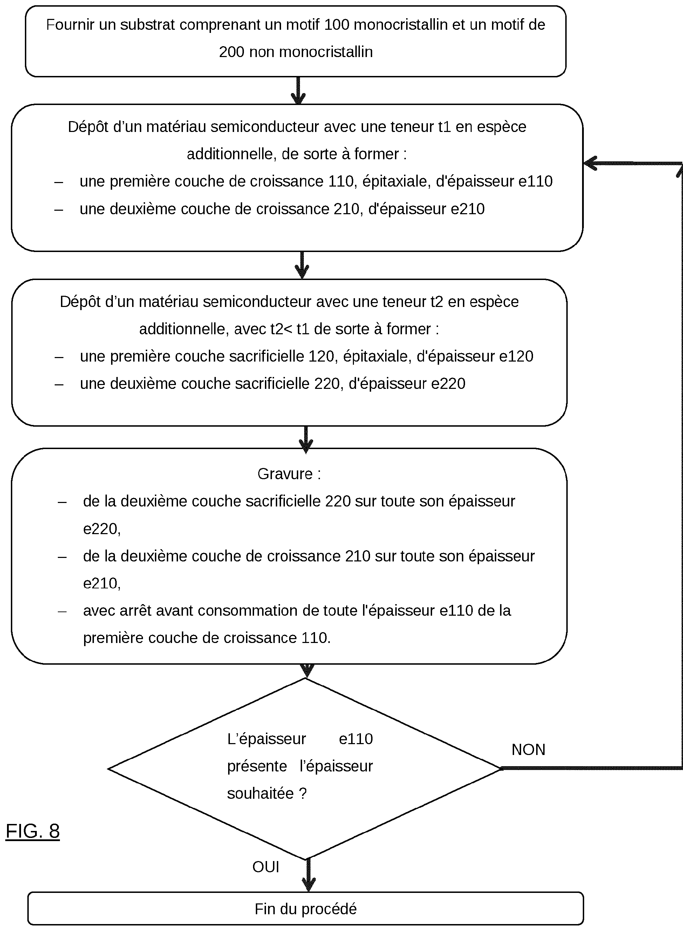

Comme illustré en figure 8, cette séquence d'étapes est réitérée jusqu'à à ce que la première portion 110 de couche de croissance surmontant le motif 100 monocristallin présente l'épaisseur e₁₁₀ finale souhaitée.

Ces étapes vont être décrites en détail par la suite en référence aux figures 2A à 7B. Une première séquence d'étapes est décrite en référence aux figures 2A à 3B.

La figure 2A illustre le résultat obtenu après deux dépôts successifs par épitaxie.

Le premier dépôt conduit à la formation de la première portion 110 de couche de croissance sur le motif 100 monocristallin et à la formation de la deuxième portion 210 de couche de croissance sur le motif 200 qui n'est pas monocristallin.

Dans cet exemple, les couches de croissance 110 et 210 sont directement au contact des motifs 100 et 200. Alternativement, on peut prévoir au moins une couche intermédiaire entre les couches de croissance 110, 210 et respectivement les motifs 100, 200. Dans ce cas, la ou les couches intermédiaires doivent reproduire le type de nature cristalline des motifs 100, 200. Ainsi, la couche intermédiaire sous-jacente à la première portion 110 de couche de croissance doit être monocristalline et la couche intermédiaire sous-jacente à la deuxième portion 210 de couche de croissance ne doit pas être monocristalline.

Dans cet exemple, les couches de croissance 110 et 210 sont obtenues par un dépôt de silicium dopé au phosphore (Si :P).

L'espèce semiconductrice est donc du silicium. Elle est par exemple introduite dans la chimie de dépôt par exemple en utilisant un précurseur du silicium de type SiₙH₂+₂ₙ, n étant un entier.

L'espèce additionnelle, du phosphore (P), est introduite dans la chimie de dépôt par exemple en utilisant le précurseur PH₃. Ce précurseur est introduit dans le réacteur avec un débit de 0.5 sccm, selon cet exemple.

Les couches 110, 210 déposées présentent des concentrations en espèce additionnelle, ici le phosphore, qui dépendent de la teneur de cette espèce additionnelle dans la composition chimique servant dépôt. Cette teneur dépend elle-même du ratio du débit de précurseur comprenant l'espèce additionnelle sur le débit total injecté dans le réacteur de dépôt. On peut considérer que pour une teneur donnée de l'espèce additionnelle dans la chimie de dépôt, les concentrations de cette espèce additionnelle dans les couches 110 et 210 sont identiques.

Du fait de la différence de structure cristallographique, la vitesse de croissance V_{c210} est plus élevée sur le motif non monocristallin 200 que la vitesse de croissance V_{c110} sur le motif monocristallin 100.

Ainsi, en fin de dépôt l'épaisseur e₂₁₀ de la couche 210 est supérieure à l'épaisseur e₁₁₀ de la couche 110.

Il ressort en effet de la figure 2B, qu'avec un débit de PH₃ de 0.5 sccm, la vitesse de croissance du Si:P sur le motif 200 est d'environ 3.1 nm/min alors que la vitesse de croissance du Si:P sur le motif 100 n'est d'environ que 2.3 nm/min. Ces vitesses V_{c110}, V_{c210} sont référencées 10A et 20A en figure 2B.

Typiquement, au cours de ce premier dépôt par épitaxie, les épaisseurs e₁₁₀ et e₂₁₀ déposées peuvent être comprises entre 2 nm et 100 nm de préférence entre 2 nm et 50 nm nanomètres selon la durée de croissance appliquée.

A la suite de ce premier dépôt, on effectue un deuxième dépôt par épitaxie.

La teneur t2 de l'espèce additionnelle dans la chimie de ce deuxième dépôt est réglée de sorte que les couches déposées 120, 220 présentent une concentration c2 en ladite espèce additionnelle strictement inférieure à c1. La concentration c2 est, selon un exemple de réalisation particulier, nulle.

Ce deuxième dépôt conduit à la formation de la première portion 120 de couche sacrificielle sur le motif 100 monocristallin et à la formation de la deuxième portion 220 de couche sacrificielle sur le motif 200 qui n'est pas monocristallin.

Ce deuxième dépôt peut être effectué :
- directement au contact des portions 110, 210 de couche de croissance comme cela est illustré en figure 2A, ou
- au contact d'une ou plusieurs couches intermédiaires disposées entre les portions 110, 210 de couches de croissance et les portions 210, 220 de couche sacrificielle.

Dans l'exemple illustré, les portions 120, 220 de couche sacrificielle sont obtenues par un dépôt de silicium non dopé, c'est-à-dire avec une concentration c2 nulle. Ainsi, lors de cette étape le débit de l'espèce additionnelle est nul.

Lors de cette étape, du fait de la différence de structure cristallographique, la vitesse de croissance est plus élevée sur le motif 200 que sur le motif 100.

Ainsi, l'épaisseur e₂₂₀ de la couche 220 est supérieure à l'épaisseur e₁₂₀ de la couche 120.

Il ressort en effet de la figure 2B, qu'avec un débit de PH₃ de 0 sccm, la vitesse de croissance V_{c220} du Si sur le motif non monocristallin 200 est d'environ 3 nm/min alors que la vitesse de croissance V_{c120} du Si sur le motif monocristallin 100 n'est d'environ que 1.7 nm/min. Ces vitesses V_{c120}, V_{c220} de croissance sont référencées 10B et 20B en figure 2B.

Typiquement, au cours de ce deuxième dépôt par épitaxie, les épaisseurs e₁₁₀ et e₂₁₀ déposées peuvent être comprises entre 2 nm et 20 nm de préférence entre 2nm et 15 nm nanomètres.

Pour cette première séquence, les épaisseurs des couches 110, 210, 120, 220 sont référencées e₁₁₀ₐ, e₂₁₀ₐ, e₁₂₀ₐ et e₂₂₀ₐ sur la figure 2A, par comparaison aux épaisseurs qui seront déposées ou gravées lors des étapes et séquences suivantes.

La figure 3A illustre une étape de gravure configurée pour graver entièrement l'épaisseur e₂₂₀ de la deuxième portion de couche sacrificielle et entièrement l'épaisseur e₂₁₀ de la deuxième portion de couche de croissance surmontant le motif 200 qui n'est pas monocristallin.

Selon un mode de réalisation alternatif, on notera qu'il est possible de laisser subsister une portion de l'épaisseur e₂₁₀ à l'issue de chaque séquence, à condition qu'à la fin de chaque séquence l'épaisseur e₁₁₀ soit supérieure à l'épaisseur e₂₁₀. Cette portion résiduelle de l'épaisseur initiale e₂₁₀ pourra par exemple être retirée à la fin du procédé. La gravure de cette épaisseur résiduelle pourra être effectuée au cours d'une gravure finale ou au cours de la gravure de la dernière séquence comprenant chacune de dépôt et de gravure.

Ce mode de réalisation a pour effet technique de réduire l'exposition du matériau 200 à l'étape de gravure. Il permet donc de résoudre la problématique consistant réduire l'endommagement de cette couche 200.

En revanche cette étape de gravure est configurée pour laisser subsister tout ou partie de l'épaisseur e₁₁₀ de la première portion 110 de couche de croissance surmontant le motif 100 monocristallin.

Au regard des références 11A, 21A de la figure 3B, il est en effet parfaitement possible de contrôler avec précision le retrait complet des couches 210, 220 déposées sur le motif 200 tout en conservant tout ou partie de la couche 110 déposée sur le motif 100.

Pour cela il faut choisir les conditions du premier et du deuxième dépôts, notamment la première teneur t1 et la deuxième teneur t2 en espèce additionnelle de sorte à ce que V_{g220}> k.V_{g120}, V_{g120} et V_{g220} étant respectivement les vitesses de gravure de la première portion 120 de couche sacrificielle et de la deuxième portion 220 de couche sacrificielle. De préférence k est supérieure ou égal à 2, de préférence supérieur à 3 ou à 4.

Il faut également choisir les teneurs t1 et t2 en espèce additionnelle et les vitesses de croissance V_{c110}, V_{c210}, V_{c120}, V_{c220} des couches 110, 210,120, 220 ainsi que la durée de chacune de ces étapes de dépôt de sorte que les épaisseurs déposées e₁₁₀ₐ, e₂₁₀ₐ e₁₂₀ₐ, e₂₂₀ₐ soit suffisantes pour qu'il subsiste une portion au moins de l'épaisseur e₁₁₀ de la première portion 110 de couche de croissance, lorsque toute l'épaisseur e₂₁₀ₐ et toute l'épaisseur e₂₂₀ₐ sont consommées par gravure,. La portion résiduelle est notée e_{110b} en figure 3A.

De manière particulièrement avantageuse, avec le procédé revendiqué les rapports des vitesses de gravure V_{g220}/V_{g120} et V_{g210}/V_{g120} sont supérieurs au rapport des vitesses de croissance V_{c220/}V_{g120},. Dès lors, plus l'on fait durer la deuxième étape de dépôt, c'est-à-dire plus l'épaisseur e₁₂₀ augmente, plus il sera aisé de retirer entièrement les couches 210 et 220 en laissant en place une épaisseur e_{110b} importante de la première portion 110 de couche de croissance.

On notera que l'invention autorise une augmentation de la teneur en dopant par rapport aux valeurs des exemples mentionnés ci-dessus. Par exemple, si lors du premier dépôt on choisit d'augmenter fortement le débit de PH3 (1.5 sccm ou plus), il restera parfaitement possible de mettre en œuvre le principe de l'invention.

On notera également, qu'il est possible qu'avec d'autres types d'éléments additionnels, typiquement d'autres dopants, les vitesses de gravure V_{g110} et V_{g210} peuvent être identiques entre-elles en présence de dopants (ainsi les courbes 11 et 21 pourraient être superposées à partir d'un seuil donné de dopants). Du fait que V_{g220} soit très supérieure à V_{g120} pour une concentration nulle ou faible en dopant, alors il restera parfaitement possible de graver entièrement les couches déposées sur les motifs 200 non monocristallins tout en conservant une couche sur les motifs 100 monocristallins.

En fonction des conditions de dépôt et de gravure (notamment en fonction de l'épaisseur e₁₂₀ₐ), on peut avoir e₁₁₀ₐ = e_{110b}. Cela signifie que lorsque toute l'épaisseur e₂₂₀ₐ et toute l'épaisseur e₂₁₀ₐ sont retirées, la gravure n'a pas commencé à consommer la première portion 110 de couche de croissance. En pratique, il peut y avoir une consommation d'une partie de la première portion 110 de couche de croissance. Dans ce cas, et comme cela est illustré en figure 3A, e₁₁₀ₐ > e_{110b}.

L'arrêt de cette gravure s'effectue au temps. On veillera à retirer toute l'épaisseur e₂₁₀ de la deuxième portion 210 de couche de croissance. On veillera de préférence à ne pas consommer le motif 200 qui n'est pas monocristallin. On veillera également à consommer un minimum de l'épaisseur e₁₁₀ de la première portion 110 de couche de croissance.

On notera qu'il est possible que les couches sacrificielles 120, 220 comportent une concentration c2 en l'espèce additionnelle qui ne soit pas nulle. Cela peut résulter d'une inévitable incorporation d'espèces dans les couches sacrificielles 120, 220, voire d'une migration de ces espèces depuis les couches sous-jacentes. Cette présence d'espèce additionnelle dans les couches sacrificielles 120, 220 peut également être volontaire. En effet, le procédé de la présente invention tire profit de la variation du rapport R= V_{g2}/V_{g1} (V_{g2} étant la vitesse de gravure des couches déposées sur les des parties non-monocristallines et V_{g1} étant la vitesse de gravure des couches déposées sur les des parties monocristallines) en fonction des concentrations c1 et c2 en espèce additionnelle au sein des couches déposées. Il est alors parfaitement possible d'envisager que les couches sacrificielles 120, 220 présentent une concentration c2 en espèce additionnelle non nulle à partir du moment où cette concentration c2 conduit à un rapport R2=V_{g220}/V_{g120} suffisamment élevé, par exemple supérieur à 2, pour permet de consommer toute ou partie de l'épaisseur e₂₁₀ avant que toute l'épaisseur e₁₂₀ soit consommée.

Par exemple, et sans que cela soit limitatif, cette gravure peut être effectuée en utilisant une chimie à base de CI2 sous N2.

Comme indiqué, ci-dessus au cours de cette étape de gravure une partie au moins de l'épaisseur e₁₂₀ de la première portion de couche sacrificielle est gravée. Par conséquent, à l'issue de cette étape de gravure, il est avantageux de prévoir que :
- toute l'épaisseur e₁₂₀ de la première portion 120 de couche sacrificielle est gravée, et
- toute l'épaisseur e₁₁₀ de la première portion 110 de couche de croissance est conservée, ou tout au moins, une partie de l'épaisseur e₁₁₀ de la première portion 110 de couche de croissance est conservée.

Selon un mode de réalisation alternatif, on peut prévoir qu'à l'issue de l'étape de gravure seule une partie de l'épaisseur e₁₂₀ de la première portion 120 de couche sacrificielle est gravée.

Le procédé selon l'invention peut être interrompu à la fin de cette étape de gravure. L'épaisseur de la couche semi conductrice 110 obtenue est donc e_{110b}.

Au contraire, si l'on a besoin d'obtenir une épaisseur plus importante pour cette couche semi conductrice 110, on peut alors réitérer cette séquence d'étapes une ou plusieurs fois.

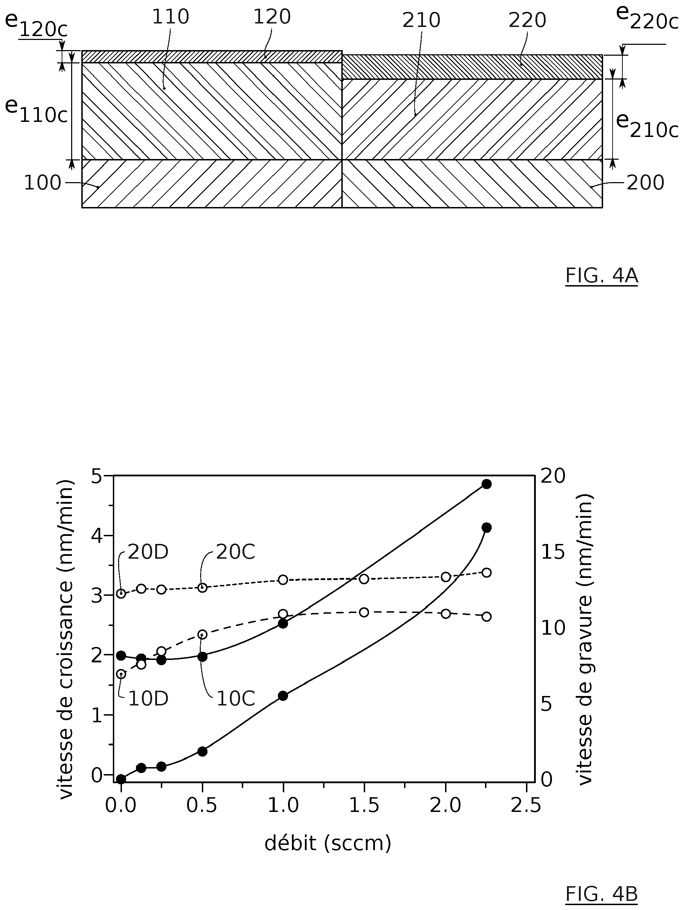

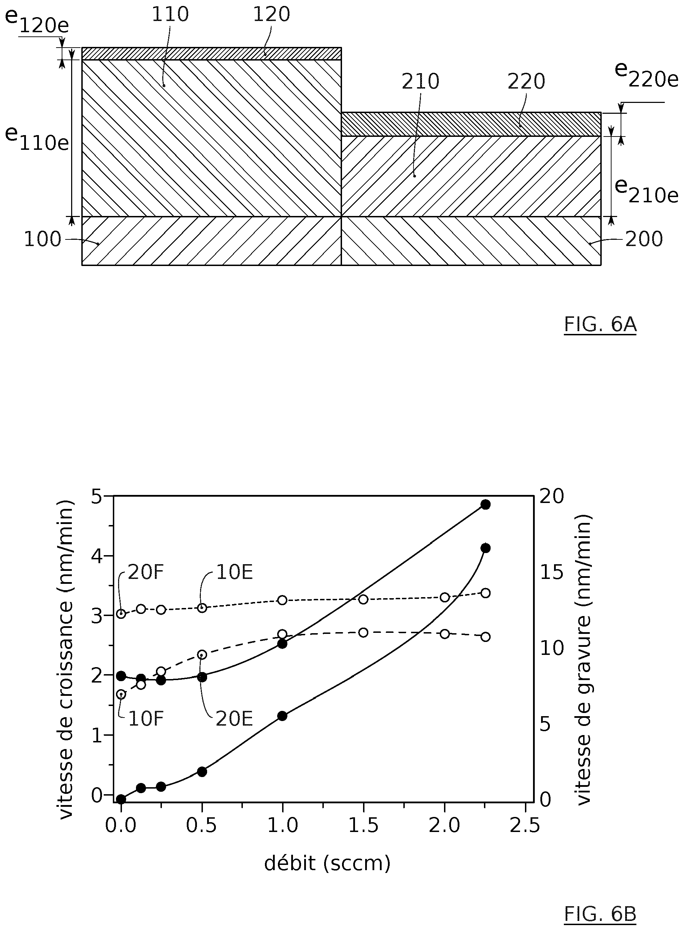

Ainsi, les figures 4A à 5B illustrent une deuxième séquence d'étapes et les figures 6A à 7B illustrent une troisième séquence d'étapes.

Ainsi, et comme illustré en figure 4A, on effectue au cours d'une deuxième séquence, une étape de premier dépôt du matériau semi-conducteur en présence de l'élément additionnel, du phosphore dans cet exemple non limitatif.

Au cours de ce premier dépôt, la teneur de l'élément additionnel est fonction du débit de cet élément, ou plus précisément du précurseur (ici du PH₃) de cet élément additionnel, dans le réacteur de dépôt. Comme illustré sur l'exemple non limitatif de la figure 4B, ce débit est de 0.5 sccm (voir références 10C et 20C).

À l'issue de ce dépôt, la première portion 110 de couche de croissance située sur le motif monocristallin 100 présente une épaisseur e_{110c}. Cette épaisseur e_{110c} est égale à la somme de l'épaisseur e_{110b} de la couche résiduelle obtenue à l'issue de l'étape 3A et de l'épaisseur nouvellement déposée au cours de l'étape illustrée en figure 4A.

Au cours de cette étape de dépôt, une deuxième portion 210 de couche de croissance, d'épaisseur e_{210c} est déposée sur le motif non monocristallin 200.

Au cours de cette deuxième séquence, on effectue une étape de deuxième dépôt, consistant à déposer un matériau semi-conducteur sans l'élément additionnel ou avec une concentration en élément additionnel, au sein de la couche déposée, inférieure à celle du premier dépôt de cette deuxième séquence.

Comme illustré sur l'exemple non limitatif de la figure 4B, ce débit est nul (voir références 10D et 20D). Ce deuxième dépôt conduit donc à la formation de couche sacrificielle en Si non dopé.

Ce deuxième dépôt conduit à la formation :
- de la couche sacrificielle 120, surmontant le motif 100 monocristallin et présentant l'épaisseur e_{120c}, et
- de la couche sacrificielle 220, surmontant le motif 200 non monocristallin et présentant l'épaisseur e_{220c}.

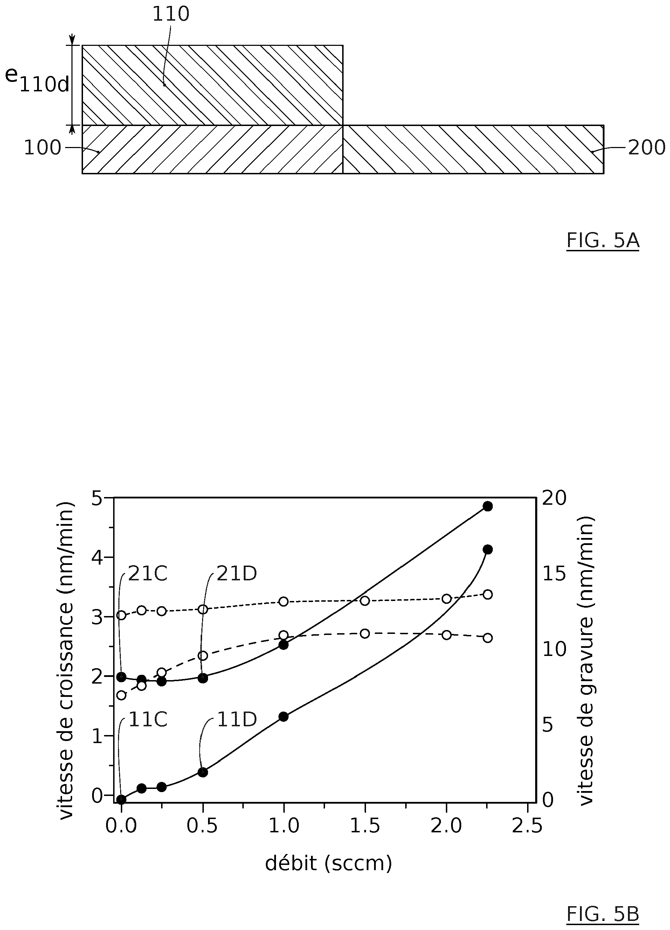

Ce deuxième dépôt est suivi de l'étape de gravure illustrée en figure 5A.

Au cours de cette étape, qui utilise de préférence la même chimie gravure que l'étape 3A, on grave toute l'épaisseur e₂₂₀ et toute l'épaisseur e₂₁₀ des couches 220 et 210 situées sur le motif 200 non monocristallin, et on stoppe la gravure de sorte à conserver entièrement ou partiellement la première portion 110 de couche de croissance située sur le motif 100 monocristallin.

L'épaisseur de la première portion 110 de couche de croissance conservée est référencée e_{110d} en figure 5A.

Les conditions du premier dépôt, du deuxième dépôt et de la gravure de cette deuxième séquence sont réglées de sorte que e_{110d} > e_{110b}. Ainsi, cette deuxième séquence permet d'épaissir la couche de croissance 110 obtenue à l'issue de la première séquence.

La figure 5B illustre les vitesses de gravure applicables pour les teneurs sélectionnées en espèce additionnelle (voir références 11C, 21C pour les couches 120 et 220 et références 11D, 21D pour les couches 110 et 210).

Une troisième séquence d'étapes est illustrée en référence aux figures 6A à 7B.

Les figures 6A et 6B illustrent les premier et deuxième dépôts de cette troisième séquence. Le premier dépôt de cette troisième séquence conduit à l'épaississement de la première portion 110 de couche de croissance formée sur le motif monocristallin 100. Cette couche 110 présente alors une épaisseur e₁₁₀ₑ> e_{110d}.

Au cours de ce premier dépôt, la couche de croissance 210 est également formée sur le motif 200 non monocristallin.

Ce premier dépôt est effectué avec les conditions illustrées par les références 10E et 20E en figure 6B : le débit de PH₃ est égal à 0.5 sccm.

Le deuxième dépôt de cette troisième séquence conduit à la formation des couches sacrificielles 120 et 220.

Ce deuxième dépôt est effectué avec les conditions illustrées par les références 10F et 20F en figure 6B : le débit de PH3 est nul.

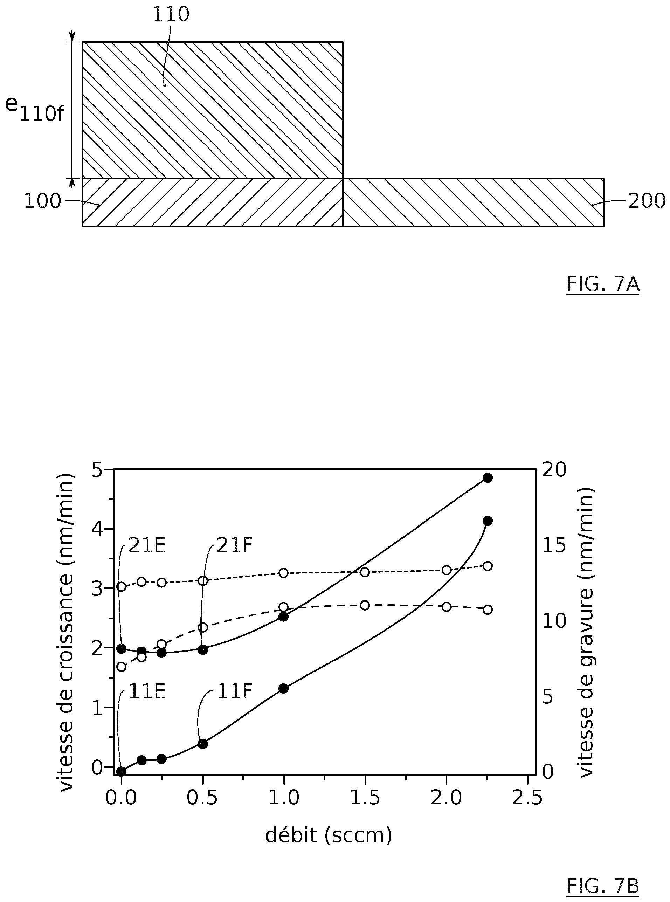

Ce deuxième dépôt est suivi de l'étape de gravure illustrée en figure 7A.

Au cours de cette étape, qui utilise de préférence la même chimie de gravure que l'étape 3A, on grave toute l'épaisseur e₂₂₀ₑ et toute l'épaisseur e₂₁₀ₑ des couches 220 et 210 situées sur le motif 200 non monocristallin, et on stoppe la gravure de sorte à conserver entièrement ou partiellement la première portion 110 de couche de croissance située sur le motif 100 monocristallin.

L'épaisseur de la couche de croissance 110 conservée est référencée e_{110f} en figure 7A.

Les conditions du premier dépôt, du deuxième dépôt et de la gravure de cette troisième séquence sont réglées de sorte à ce que e_{110f} > e_{110d}. Ainsi, cette troisième séquence permet d'épaissir la première portion 110 de couche de croissance obtenue à l'issue de la deuxième séquence.

La figure 7B illustre les vitesses de gravure applicables pour les teneurs sélectionnées en espèce additionnelle (voir références 11E, 21E pour les couches 120 et 220 et références 11F, 21F pour les couches 110 et 210).

De manière optionnelle, à l'issue de la gravure de la dernière séquence, on peut effectuer une étape de sur-gravure afin de s'assurer que toute la deuxième portion 210 de couche de croissance surmontant le motif 200 non monocristallin est effectivement retirée. À cet effet, on peut prévoir une gravure basée sur une chimie de type Cl2.

Alternativement, on peut se passer d'une étape additionnelle de sur-gravure. Dans ce cas on peut rallonger la durée de la gravure de la dernière séquence.

Au vu de la description qui précède, il apparaît clairement que l'invention offre une solution simple et aisément reproductible pour former une couche semi conductrice dopée ou additionnée d'un élément, sur un motif monocristallin, sans pour autant former cette couche sur un motif non monocristallin.

Plusieurs variantes peuvent être apportées aux modes de réalisation non limitatifs décrits dans les paragraphes ci-dessus en référence aux figures 1A à 7A.

Par exemple, on peut prévoir que l'élément semi-conducteur utilisé pour le premier dépôt est différent de l'élément semi-conducteur utilisé pour le deuxième dépôt. Ainsi on peut avoir des couches de croissance 110, 210 à base d'un premier élément semi-conducteur et des couches sacrificielles 120, 220 à base d'un deuxième élément semi-conducteur. À titre d'exemple, les couches de croissance 110, 210 peuvent être des couches de silicium dopé ou additionné d'un élément et les couches sacrificielles 120, 220 peuvent être des couches de germanium ou de silicium-germanium (intrinsèque ou présentant une concentration inférieure en dopants ou en éléments additionnels).

Par ailleurs la durée des étapes de dépôt et de gravure peut être fixe ou variable d'une séquence à l'autre. Ainsi, on peut prévoir de déposer des couches d'épaisseurs différentes selon les différentes séquences.

De même, la teneur en espèce additionnelle (typiquement dopants) peut varier d'une séquence à l'autre.

Naturellement, les précurseurs utilisés pour les premier et deuxième dépôts peuvent être adaptés en fonction de la couche de croissance que l'on souhaite déposer. Les précurseurs seront également choisis en fonction des températures possibles pour le dépôt.

Typiquement, la plage de température pour la mise en œuvre du procédé selon l'invention est comprise entre 150 °C et 750 °C et de préférence entre 250 °C et 600 °C.

Les précurseurs du silicium peuvent par exemple être tous composés de type SiₙH₂₊₂ₙ, n étant un entier ou dichlorosilane (DCS).

Les précurseurs du germanium peuvent par exemple être du GeH₄ ou du Ge₂H₆.

Les précurseurs du bore (B) peuvent par exemple être du 8₂H₆.

Les précurseurs du phosphore (P) peuvent par exemple être du PH₃

L'invention n'est pas limitée aux modes de réalisations précédemment décrits et s'étend à tous les modes de réalisation couverts par les revendications.

## Revendications

1. Procédé de formation d'une couche par épitaxie cyclée comprenant les étapes suivantes:
- fournir une plaque comprenant au moins un premier motif (100) monocristallin et au moins un deuxième motif (200) pris parmi un motif amorphe ou un motif polycristallin,
- effectuer au moins une séquence d'étapes comprenant chacune au moins les étapes successives suivantes :
∘ premier dépôt de sorte à former,
▪ une première portion (110) de couche de croissance, semiconductrice, formée par épitaxie sur le premier motif (100) et présentant une épaisseur e₁₁₀, et
▪ une deuxième portion (210) de couche de croissance semiconductrice, formée sur le deuxième motif (200) et présentant une épaisseur e₂₁₀,
au moins du fait de la différence de structure cristalline entre les premier (100) et deuxième (200) motifs, à l'issue du premier dépôt, les épaisseurs e₂₁₀ et e₁₁₀ sont telles que e₂₁₀ > e₁₁₀,
le premier dépôt étant réalisé à partir d'une première chimie comprenant une première espèce semi-conductrice et une espèce additionnelle présentant dans la première chimie une première teneur t1,
∘ deuxième dépôt de sorte à former:
▪ une première portion (120) de couche sacrificielle, semiconductrice, formée par épitaxie sur la première portion (110) de couche de croissance et présentant une épaisseur e₁₂₀, et
▪ une deuxième portion (220) de couche sacrificielle, semiconductrice, formée sur la deuxième portion (210) de couche de croissance et présentant une épaisseur e₂₂₀,
le deuxième dépôt étant réalisé à partir d'une deuxième chimie comprenant une deuxième espèce semi-conductrice et présentant une deuxième teneur t2 en ladite espèce additionnelle, telle 0 ≤t2<t1,
∘ gravure de toute l'épaisseur e₂₂₀ de la deuxième portion (220) de couche sacrificielle, d'une partie au moins de l'épaisseur e₁₂₀ de la première portion (120) de couche sacrificielle et d'une partie au moins de l'épaisseur e₂₁₀ de la deuxième portion de couche de croissance (210) avec arrêt de la gravure avant d'avoir consommé toute l'épaisseur e₁₁₀ de la première portion (110) de couche de croissance.

2. Procédé selon la revendication précédente dans lequel ladite première espèce semi-conductrice et ladite deuxième espèce semi-conductrice sont identiques.

3. Procédé selon la revendication 1 dans lequel ladite première espèce semi-conductrice et ladite deuxième espèce semi-conductrice sont différentes.

4. Procédé selon l'une quelconque des revendications précédentes dans lequel les conditions du premier et deuxième dépôts, notamment la première teneur t1 et la deuxième teneur t2, ainsi que les conditions de la gravure sont réglées de sorte que ;
- V_{g220}> k.V_{g120}, V_{g120} et V_{g220} étant respectivement les vitesses de gravure de la première portion (120) de couche sacrificielle et de la deuxième portion (220) de couche sacrificielle, k étant supérieure ou égal à 2,
- l'épaisseur e₁₂₀ de la première portion (120) de couche sacrificielle formée par le deuxième dépôt soit suffisante pour que, après ladite gravure, il subsiste une portion au moins de l'épaisseur e₁₁₀ de la première portion (110) de couche de croissance déposée sur le premier motif (100) de sorte que, après gravure e₁₁₀ >0 et e₁₁₀ > e₂₁₀.

5. Procédé selon l'une quelconque des revendications précédentes dans lequel la première portion (110) de couche de croissance et la deuxième portion (210) de couche de croissance sont des couches à base de l'un parmi le silicium et le germanium, la première portion (120) de couche sacrificielle et la deuxième portion (220) de couche sacrificielle étant également des couches à base de l'un parmi le silicium et le germanium.

6. Procédé selon l'une quelconque des revendications précédentes dans lequel l'espèce additionnelle est un dopant.

7. Procédé selon l'une quelconque des revendications précédentes dans lequel la deuxième teneur t2 est nulle.

8. Procédé selon l'une quelconque des revendications 1 à 6 dans lequel :
- soit la première portion (110) de couche de croissance et la deuxième portion (210) de couche de croissance sont faites: de silicium dopé au phosphore (Si :P) et la première portion (120) de couche sacrificielle et la deuxième portion (220) de couche sacrificielle sont faites de silicium (Si),
- soit la première portion (110) de couche de croissance et la deuxième portion (210) de couche de croissance sont faites de silicium-germanium dopé au bore (SiGe :B) et la première portion (120) de couche sacrificielle et la deuxième portion (220) de couche sacrificielle sont faites de silicium-germanium (SiGe).

9. Procédé selon l'une quelconque des revendications précédentes dans lequel les épaisseurs e₁₁₀ de la première portion (110) de couche de croissance et e₂₁₀ de la deuxième portion (210) de couche de croissance sont comprises entre 2 nm et 100 nm et de préférence entre 2 nm et 50 nm.

10. Procédé selon l'une quelconque des revendications précédentes dans lequel les épaisseurs e₁₂₀ de la première portion (120) de couche sacrificielle et e₂₂₀ de la deuxième portion (220) de couche sacrificielle sont comprises entre 2 nm et 50 nm et de préférence entre 2 nm et 20 nm.

11. Procédé selon l'une quelconque des revendications précédentes dans lequel les conditions de la gravure, en particulier Vg120, Vg210, Vg220 et les épaisseurs e₁₂₀ et e₁₁₀ sont choisies de sorte que, après gravure de toute l'épaisseur e₂₁₀ et de toute l'épaisseur e₂₂₀, il subsiste toute l'épaisseur e₁₁₀ de la première portion (110) de couche de croissance déposée sur le premier motif (100), V_{g120}, V_{g210} et V_{g220} étant respectivement les vitesses de gravure de la première portion (120) de couche sacrificielle, de la deuxième portion (210) de couche de croissance et de la deuxième portion (220) de couche sacrificielle.

12. Procédé selon l'une quelconque des revendications précédentes dans lequel, après le premier dépôt et après le deuxième dépôt, lors de ladite gravure on grave également toute l'épaisseur e₂₁₀ de la deuxième portion (210) de couche de croissance.

13. Procédé selon l'une quelconque des revendications 1 à 12 comprenant plusieurs séquences, et dans lequel, on grave toute l'épaisseur e₂₁₀ de la deuxième portion (210) de couche de croissance uniquement lors de la gravure de la dernière séquence de ladite pluralité de séquences.

14. Procédé selon l'une quelconque des revendications précédentes dans lequel le procédé comprend, après avoir effectué l'au moins une séquence d'étapes, une étape de gravure finale configurée pour retirer un éventuel résidu de la deuxième portion (210) de couche de croissance.

15. Procédé selon l'une quelconque des revendications précédentes dans lequel ladite séquence d'étapes est réitérée au moins deux fois et de préférence au moins trois fois.
